# EUROPÄISCHE PATENTSCHRIFT

(11) **EP 1 552 612 B1**
(45) Veröffentlichungstag und Bekanntmachung des Hinweises auf die Patenterteilung: **30.01.2008**
(21) Anmeldenummer: 03775049.4
(22) Anmeldetag: 02.10.2003
(51) Int. Cl.: H03K 17/06

(54) **SCHALTUNGSANORDNUNG ZUR SPANNUNGSREGELUNG**
CIRCUIT ARRANGEMENT FOR REGULATING VOLTAGE
CIRCUITERIE DE REGULATION DE TENSION

(30) Priorität: 17.10.2002 DE 10248498
(43) Veröffentlichungstag der Anmeldung: 13.07.2005
(73) Patentinhaber: Infineon Technologies AG, 81669 München (DE)
(72) Erfinder: BAGLIN, Thomas, Jean, Ludovic, 8020 Graz (AT); NEBEL, Gerhard, 87509 Immenstadt (DE)
(74) Vertreter: Epping - Hermann - Fischer
(86) Internationale Anmeldenummer: PCT/DE2003/003283
(87) Internationale Veröffentlichungsnummer: WO 2004/040760

(56) Entgegenhaltungen:
- US-A- 5 654 628
- US-A- 6 049 201
- US-A- 6 114 876
- US-B1- 6 188 212
- US-B1- 6 201 375
- US-B1- 6 396 334

## Beschreibung

### Technisches Gebiet

Die Erfindung betrifft eine Schaltungsanordnung zur Spannungsregelung.

Spannungsregler, die auf einer N-Kanal-MOS (NMOS)-Technologie beruhen, eignen sich zur Steuerung bzw. Regelung von stark rauschbehafteten Energieversorgungen. Nachteilhafterweise benötigen NMOS-Spannungsregler jedoch eine Ladungspumpe, um die Spannung am Gate des NMOS-Transistors ausreichend erhöhen zu können. Insbesondere bei tragbaren Anwendungen ist es jedoch von Nachteil, dass die Ladungspumpe während des Betriebs einen erheblichen Stromverbrauch aufweist.

### Stand der Technik

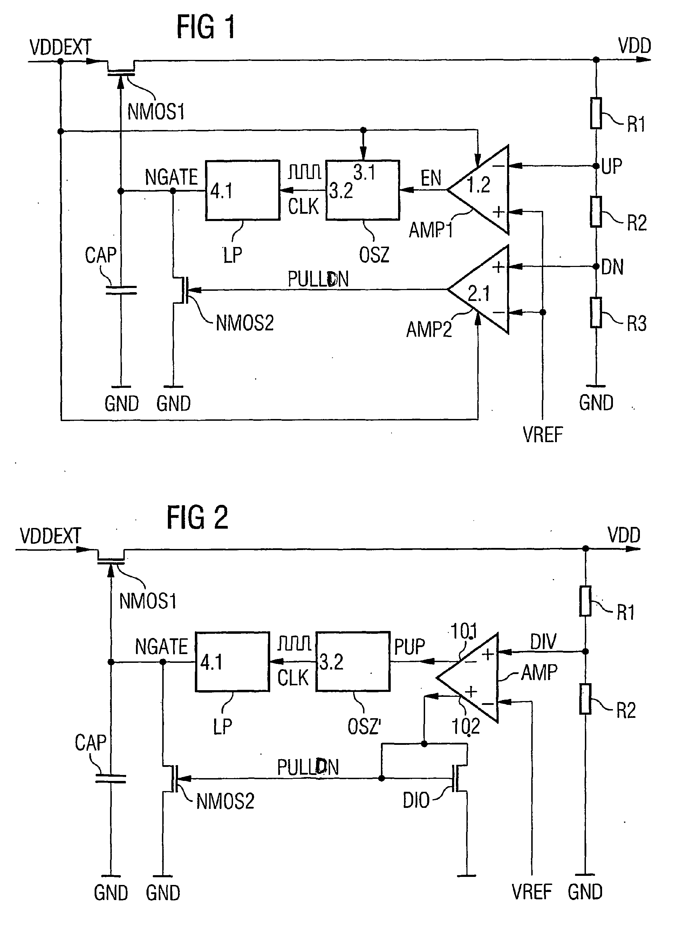

Aus dem betriebsinternen Stand der Technik ist, wie in Figur 1 gezeigt ist, eine Schaltungsanordnung bekannt, bei der der Stromverbrauch der Ladungspumpe reduziert werden kann. Dazu wird die Ladungspumpe abgeschaltet, wenn die Spannung am Gate des NMOS-Transistors den richtigen Wert angenommen hat. Die Schaltungsanordnung zur Spannungsregelung in Figur 1 beruht prinzipiell auf einer binären Regelung. Die Schaltungsanordnung weist einen ersten Differenzverstärker AMP1 und einen zweiten Differenzverstärker AMP2 mit jeweils zwei Eingängen auf. Der nicht invertierende Eingang des ersten Differenzverstärkers AMP 1 sowie der invertierende Eingang des zweiten Differenzverstärkers AMP2 sind mit einem Referenzpotential VREF verbunden. Über einen Spannungsteiler, der aus drei Widerständen R1, R2 und R3 besteht, ist der invertierende Eingang des ersten Differenzverstärkers AMP1 mit dem Potenzial UP, das auch als erste Teilerspannung bezeichnet wird, und der nicht invertierende Eingang des zweiten Differenzverstärkers AMP2 mit dem Potenzial DN verbunden, das auch als zweite Teilerspannung bezeichnet wird. Der Spannungsteiler liegt zwischen der zu regelnden Spannung VDD und einem Bezugspotenzial GND. Das Potential UP ist zwischen dem ersten Widerstand R1 und dem zweiten Widerstand R2 abgreifbar. Das Potential DN ist zwischen dem zweiten Widerstand R2 und dem dritten Widerstand R3 abgreifbar. Der Ausgang EN des ersten Differenzverstärkers AMP1 führt auf den Eingang eines Oszillators OSZ. Der Oszillator OSZ mit konstanter Frequenz erzeugt, wenn an seinem Eingang EN die Spannung VDDEXT anliegt, ein Signal mit konstanter Frequenz. Liegt jedoch an seinem Eingang EN keine Spannung an, erzeugt der Oszillator OSZ an seinem Ausgang auch kein Signal. Der Ausgang des Oszillators OSZ wiederum ist mit der Ladungspumpe LP verbunden, die abhängig von der durch den Oszillator OSZ erzeugten Frequenz eine Spannung erzeugt, welche am Ladungspumpenausgang 4.1 anliegt. Der Ausgang des zweiten Differenzverstärkers AMP2 führt auf den Steuereingang eines zweiten NMOS-Transistors NMOS2. Der Ausgang der Ladungspumpe LP ist mit dem Steuerausgang des NMOS-Transistors NMOS2, einem Kondensator CAP und dem Steuereingang des NMOS-Transistors NMOS1 verbunden. Die am Eingang VDDEXT der Schaltung anliegende externe Versorgungsspannung VDDEXT wird einerseits auf den Drain-Anschluss des ersten NMOS-Transistors NMOS1 und andererseits auf den Versorgungsanschluss 1.2 des ersten Differenzverstärkers AMP1, den Steueranschluss 3.1 des Oszillators OSZ mit konstanter Frequenz sowie auf den Versorgungsanschluss 2.1 des zweiten Differenzverstärkers AMP2 geführt.

Das Prinzip, das sich hinter der Schaltungsanordnung zur Spannungsregelung, wie sie in Figur 1 gezeigt ist, verbirgt, besteht darin, den Kondensator CAP als Speicherelement zu benutzen und zudem die Ladungspumpe LP sowie den NMOS-Transistor NMOS2 nur einzuschalten, falls die Spannung am Gate des NMOS-Transistor NMOS1 erhöht oder verringert werden soll. Für die Zeit, für die die Ladungspumpe LP ausgeschaltet ist, wird die Spannung im Kondensator CAP gespeichert. Die beiden Differenzverstärker AMP1 und AMP2 arbeiten als Komparatoren. Mit Hilfe der Referenzspannung VREF und den beiden Komparatoren AMP1 und AMP2 kann ein Spannungsfenster erzeugt werden. Wenn die Versorgungsspannung oder Betriebsspannung VDD zu niedrig ist, das heißt, außerhalb des Spannungsfensters liegt, wird die Ladungspumpe LP aktiviert. Wenn die Versorgungsspannung VDD zu hoch ist, wird über den zweiten NMOS-Transistor NMOS2 das Gate des ersten NMOS-Transistors NMOS1 entladen. Solange die Versorgungsspannung VDD innerhalb des Spannungsfensters liegt, wird weder die Ladungspumpe LP noch der zweite NMOS-Transistor NMOS2 aktiviert. Damit wird der Stromverbrauch reduziert. Außer den beiden Differenzverstärkern AMP1 und AMP2 verbrauchen dann weder der Oszillator OSZ, noch die Ladungspumpe LP noch der zweite NMOS-Transistor NMOS2 Strom.

Im Detail funktioniert die in Figur 1 dargestellte Schaltung wie folgt. Wenn die Versorgungsspannung VDD den nominellen Wert aufweist, liegt die Referenzspannung VREF zwischen den durch den Spannungsteiler erzeugten Potentialen UP und DN. Dies hat zur Folge, dass die Spannung am Ausgang EN des ersten Differenzverstärkers AMP 1 und die Spannung am Ausgang PULLDN des zweiten Differenzverstärkers AMP2 auf dem Wert 0 liegen. Dies wiederum hat zur Folge, dass die Ladungspumpe LP deaktiviert wird und der zweite NMOS-Transistor NMOS2 abgeschaltet ist. Die Spannung am Knoten NGATE und damit am Gate des NMOS-Transistors NMOS1 wird daher weder von der Ladungspumpe LP noch vom NMOS-Transistor NMOS2 beeinflusst. Mit Hilfe des Kondensators CAP wird vermieden, dass die Spannung am Knoten NGATE abdriftet.

Wenn die Versorgungsspannung VDD einen zu hohen Wert annimmt, steigt das Potential DN über die Referenzspannung VREF. Dies bewirkt, dass mit Hilfe des zweiten Differenzverstärkers AMP2 die Spannung am Ausgang PULLDN des zweiten Differenzverstärkers AMP2 vom Wert 0 auf den Wert der externen Versorgungsspannung VDDEXT ansteigt. Damit wird der Knoten NGATE und das Gate des NMOS-Transistors NMOS1 über den zweiten NMOS-Transistor NMOS2 auf das Bezugspotenzial GND gezogen. Dies hat zur Folge, dass der Strom, der vom Eingang VDDEXT der Schaltung zum Ausgang VDD der Schaltung fließt, abnimmt. Die Versorgungsspannung VDD nimmt damit solange ab, bis die Referenzspannung VREF wieder zwischen den beiden Potenzialen UP und DN liegt.

Wenn die Versorgungsspannung VDD zu stark abnimmt, fällt das Potential UP unter den Wert der Referenzspannung VREF. Die Spannung am Ausgang EN des ersten Differenzverstärkers AMP1 wechselt dann vom Wert 0 auf den Wert der externen Versorgungsspannung VDDEXT und der Oszillator OSZ zur Erzeugung einer konstanten Frequenz wird aktiviert. Der Oszillator OSZ erzeugt ein Signal CLK mit einer konstanten Frequenz, was dazu führt, dass die Ladungspumpe LP die Spannung am Knoten NGATE erhöht. Damit nimmt der Strom, der zwischen dem Eingang VDDEXT der Schaltung und dem Ausgang VDD der Schaltung fließt, zu, was dazu führt, dass die Versorgungsspannung VDD ansteigt, bis die Referenzspannung VREF wieder zwischen den beiden Potentialen UP und DN liegt.

Eine derartige Schaltung hat jedoch den Nachteil, dass sie als digitales System ausgebildet ist. Die Schaltung ist daher nicht in der Lage, sich an den Grad der Abweichung der Versorgungsspannung VDD anzupassen. Unabhängig davon, ob die Versorgungsspannung VDD weit von ihren nominellen Wert entfernt ist oder nahe daran liegt, wird mit Hilfe der Ladungspumpe LP und des zweiten NMOS-Transistors NMOS2 immer die gleiche Spannung am Knoten NGATE erzeugt. Daher ist ein Kompromiss zwischen der Regelgeschwindigkeit des Systems und der Welligkeit der Versorgungsspannung VDD erforderlich. Wenn die Ladungspumpe LP und der zweite NMOS-Transistor NMOS2 zu stark sind, wird das System zwar schnell, das heißt, das System ist dann schnell einschaltbar und eine durch eine Änderung der Last bedingte Änderung der Versorgungsspannung VDD wird schnell ausgeglichen, aber gleichzeitig weist die Versorgungsspannung VDD dann große Spannungsstufen auf, wenn die Ladungspumpe LP, der Oszillator OSZ und der zweite NMOS-Transistor NMOS2 ein- und ausgeschaltet werden.

### Darstellung der Erfindung

Eine Aufgabe der Erfindung ist es daher, eine Schaltungsanordnung zur Spannungsregelung anzugeben, bei der einerseits der Stromverbrauch so gering wie möglich ist und andererseits keine großen Spannungsstufen auftreten, wenn sich die Last am Ausgang der Schaltung verändert.

Die Aufgabe wird durch eine Schaltungsanordnung zur Spannungsregelung mit den Merkmalen gemäß Patentanspruch 1 gelöst.

So weist die erfindungsgemäße Schaltungsanordnung zur Spannungsregelung einen Differenzverstärker mit zwei Eingängen und zwei Ausgängen auf, wobei an die Eingänge eine Referenzspannung und eine zur regelnde Spannung anlegbar sind. Zudem ist eine Ladungspumpe vorgesehen, die mit dem ersten Ausgang des Differenzverstärkers verbunden ist. Weiterhin ist ein Stromspiegel vorgesehen, der mit dem zweiten Ausgang des Differenzverstärkers verbunden ist. Über einen Transistor, dessen Steuereingang mit dem Stromspiegel und der Ladungspumpe verbunden ist, ist die zur regelnde Spannung beeinflussbar.

Vorteilhafte Weiterbildungen der Erfindung ergeben sich aus den in den abhängigen Patentansprüchen angegebenen Merkmalen.

Bei einer Ausführungsform der Erfindung ist ein Kondensator zum Speichern vorgesehen, der mit dem Steuereingang des Transistors verbunden ist.

Vorteilhafterweise ist bei der erfindungsgemäßen Schaltungsanordnung zur Spannungsregelung ein Spannungsteiler vorgesehen, der eingangsseitig mit der zu regelnden Spannung und ausgangsseitig mit dem Eingang des Differenzverstärkers verbunden ist.

Entsprechend einer bevorzugten Ausführungsvariante der Erfindung weist der Stromspiegel einen ersten Stromspiegeltransistor und einen zweiten Stromspiegeltransistor auf, wobei deren Steuereingänge miteinander verbunden sind.

Bei einer Weiterbildung der erfindungsgemäßen Schaltungsanordnung ist ein steuerbarer Oszillator vorgesehen, der zwischen den Ausgang des Differenzverstärkers und die Ladungspumpe geschaltet ist.

Darüber hinaus kann bei der erfindungsgemäßen Schaltungsanordnung der steuerbare Oszillator als stromgesteuerter Oszillator ausgebildet sein.

Zur Lösung der Aufgabe wird ferner vorgeschlagenen den Transistor als N-Kanal-MOS-Transistor auszubilden.

Schließlich kann die erfindungsgemäße Schaltungsanordnung zur Spannungsregelung in einer tragbaren elektronischen Vorrichtung verwendet werden.

### Kurze Beschreibung der Zeichnungen

Im folgen wird die Erfindung anhand von zwei Figuren weiter erläutert.
- Figur 1: zeigt in Form eines Schaltplans den prinzipiellen Aufbau einer Schaltung zur Spannungsregelung gemäß dem Stand der Technik.
- Figur 2: zeigt in Form eines Schaltplans den prinzipiellen Aufbau einer Schaltung zur Spannungsregelung gemäß der Erfindung.

### Wege zur Ausführung der Erfindung

Auf die Ausführungsform gemäß Figur 1 wird im folgenden nicht weiter eingegangen, da dies bereits in der Beschreibungseinleitung hinreichend erfolgte.

Bei der in Figur 2 gezeigten erfindungsgemäßen Schaltungsanordnung zur Spannungsregelung ist ein Differenzverstärker AMP mit einem invertierenden Eingang, einen nicht invertierenden Eingang, einem invertierenden Ausgang 10.1 und einen nicht invertierenden Ausgang 10.2 vorgesehen. Der invertierende Eingang des Differenzverstärkers AMP ist mit einem Referenzpotential VREF verbunden, während der nicht invertierende Eingang des Differenzverstärkers AMP mit dem Ausgang eines Spannungsteilers verbunden ist. Der Spannungsteiler besteht aus zwei in Reihe geschalteten Widerständen R1 und R2, wobei der zweite Widerstand R2 mit dem Bezugspotenzial GND und der erste Widerstand R1 mit der Betriebsspannung VDD verbunden ist. Der Spannungsteiler erzeugt eine Teilerspannung DIV, welche am nicht invertierenden Eingang des Differenzverstärkers AMP anliegt.

Der invertierende Ausgang 10.1 des Differenzverstärkers AMP ist mit dem Eingang des Oszillators OSZ' verbunden. Je höher der Strom am Eingang des Oszillators OSZ' ist, desto größer wird die Frequenz am Ausgang des Oszillators OSZ'. Der Ausgang des Oszillators OSZ' wiederum ist mit der Ladungspumpe LP verbunden. Der nicht invertierende Ausgang 10.2 des Differenzverstärkers AMP ist mit den Gate-Anschlüssen eines ersten NMOS-Transistors DIO und eines zweiten NMOS-Transistors NMOS2 verbunden. Die beiden NMOS-Transistoren DIO und NMOS2 bilden zusammen ein Stromspiegel, der ausgangsseitig, das heißt über den Steuerausgang des zweiten NMOS-Transistors NMOS2, mit dem Ausgang 4.1 der Ladungspumpe LP, dem Kondensator CAP und dem Steuereingang des ersten NMOS-Transistors NMOS1 verbunden ist. Diese Verbindung bildet den Knoten NGATE. Die beiden NMOS-Transistor NMOS2 und DIO werden im folgenden auch als Stromspiegeltransistoren bezeichnet.

Bei der in Figur 2 gezeigten Schaltungsanordnung wird die Stärke der Ladungspumpe LP und des zweiten Stromspiegeltransistors NMOS2 in Abhängigkeit von dem Wert der Betriebsspannung VDD gesteuert. Dazu dient der Differenzverstärker AMP mit seinen beiden Stromausgängen. Der erste Stromausgang 10.1 des Differenzverstärkers AMP, welcher der invertierende Ausgang ist, wird aktiviert, wenn die Betriebsspannung VDD zu niedrig ist, was der Fall ist, wenn die Teilerspannung DIV kleiner als die Referenzspannung VREF ist. Der Ausgang 10.1 steuert den stromgesteuerten Oszillator OSZ' über den Steuerstrom UP. Der zweite Ausgang 10.2 des Differenzverstärkers AMP wird aktiviert, wenn die Betriebsspannung VDD beziehungsweise die Teilerspannung DIV gegenüber der Referenzspannung VREF zu hoch ist. Über den Ausgang 10.2 wird dann der NMOS-Transistor DIO leitend geschaltet, um das Gate des zweiten Stromspiegeltransistors NMOS2 zu laden. Der Wert des Stroms am Ausgang 10.1 und der Wert des Stroms am Ausgang 10.2 des Differenzverstärkers AMP sind proportional zur Spannungsdifferenz zwischen der Betriebsspannung VDD bzw. der Teilerspannung DIV und der Referenzspannung VREF.

Im folgenden wird die Funktionsweise der in Figur 2 gezeigten Schaltung im Detail beschrieben.

Wenn die Betriebsspannung VDD ihren nominellen Wert aufweist, erzeugt der Differenzverstärker AMP weder am Ausgang 10.1 noch am Ausgang 10.2 einen Strom. Der stromgesteuerte Oszillator OSZ' erzeugt deshalb auch kein Signal CLK am Ausgang 3.2. Da auch der Ausgang 10. 2 keinen Strom erzeugt, befindet sich der NMOS-Transistor NMOS2 im hochohmigen Zustand. Die Spannung am Knoten NGATE und damit am Gate des NMOS-Transistors NMOS1 wird somit weder von der Ladungspumpe LP noch vom NMOS-Transistor NMOS2 vorgegeben. Um zu vermeiden, dass die Spannung am Knoten NGATE abdriftet, ist der zwischen das Gate des NMOS-Transistors NMOS1 und das Bezugspotenzial GND geschaltete Kondensator CAP vorgesehen.

Wenn die Betriebsspannung VDD über den nominellen Wert steigt, erhöht der Differenzverstärker AMP seinen Strom am Ausgang 10.2 nach und nach. Am Ausgang 10.1 des Differenzverstärkers AMP hingegen wird kein Strom erzeugt. Die Ladungspumpe LP bleibt daher ausgeschaltet. Der Strom PULLDN am Ausgang 10.2 des Differenzverstärkers AMP wird mit Hilfe des Stromspiegels auf den Steuereingang des NMOS-Transistors NMOS1 gespiegelt. Auf diese Art und Weise wird, wenn die Betriebsspannung VDD über ihren nominellen Wert steigt, das Gate des NMOS-Transistors NMOS1 mehr und mehr in Richtung Bezugspotenzial GND gezogen. Der Strom, der zwischen dem Schaltungseingang VDDEXT und dem Schaltungsausgang VDD fließt, sinkt solange, bis die Betriebsspannung VDD wieder ihren nominellen Wert erreicht hat.

Wenn die Betriebsspannung VDD unter den nominellen Wert fällt, erzeugt der Differenzverstärker AMP am Ausgang 10.1 einen nach und nach zunehmenden Strom PUP. Am Ausgang 10.2 hingegen wird kein Strom erzeugt, sodass der NMOS-Transistor NMOS2 ausgeschaltet, das heißt nicht leitend, bleibt. Der stromgesteuerte Oszillator OSZ' erzeugt nun ein Signal CLK mit einer Frequenz, die proportional zur Differenz zwischen der augenblicklichen Betriebsspannung VDD und dem nominellen Wert der Betriebsspannung ist. Darauf hin wird das Gate des NMOS-Transistors NMOS1 nach und nach stärker nach oben gepumpt. Der Strom, der zwischen dem Schaltungseingang VDDEXT und dem Schaltungsausgang VDD fließt, nimmt dann solange zu, bis die Betriebsspannung VDD wieder ihren nominellen Wert erreicht hat.

Bei der in Figur 2 gezeigten Schaltungsanordnung wird somit, sobald eine Differenz zwischen der Teilerspannung DIV und der Referenzspannung VREF festgestellt wird, die entsprechend erforderliche Maßnahme, das heißt Spannung erhöhen beziehungsweise Spannung erniedrigen, eingeleitet. Dabei handelt es sich um eine analoge Regelung. Auf diese Art und Weise können große Spannungsstufen bei der Betriebsspannung VDD während der Nachführung der Betriebsspannung VDD vermieden werden, ohne dass es zu einer Verlangsamung bei der Nachführung der Betriebsspannung VDD kommt.

Die vorhergehende Beschreibung der Ausführungsbeispiele gemäß der vorliegenden Erfindung dient nur zu illustrativen Zwecken und nicht zum Zwecke der Beschränkung der Erfindung. Im Rahmen der Erfindung sind verschiedene Änderungen und Modifikationen möglich, ohne den Umfang der Erfindung sowie ihre Äquivalente zu verlassen.

### Bezugszeichenliste

- 1.2: Versorgungsanschluss des Differenzverstärkers AMP1
- 10.1: erster Ausgang
- 10.2: zweiter Ausgang
- 2.1: Versorgungsanschluss des Differenzverstärkers AMP2
- 3.1: Steuereingang des Oszillators
- 4.1: Ausgang der Ladungspumpe
- AMP: Differenzverstärker
- AMP1: erster Differenzverstärker
- AMP2: zweiter Differenzverstärker
- CAP: Kondensator
- CLK: Signal am Ausgang des Oszillators
- DIO: Stromspiegeltransistor
- DN: zweite Teilerspannung
- GND: Bezugspotenzial
- LP: Ladungspumpe
- NGATE: Gate des Transistors NMOS1
- NMOS1: erster NMOS-Transistor
- NMOS2: zweiter NMOS-Transistor
- OSZ: Oszillator mit konstanter Frequenz
- OSZ': stromgesteuerter Oszillator
- PULLDN: Steuerstrom für den NMOS2
- PUP: Steuerstrom für den OSZ'
- R1, R2, R3: Widerstände
- UP: erste Teilerspannung
- VDD: Betriebsspannung
- VREF: Referenzspannung
- VVDEXT: externe Betriebsspannung

## Patentansprüche

1. Schaltungsanordnung zur Spannungsregelung,
mit einem Differenzverstärker (AMP) mit zwei Eingängen und zwei Ausgängen, wobei an die Eingänge eine Referenzspannung (VREF) und eine zur regelnde Spannung (VDD) anlegbar sind,
mit einer Ladungspumpe (LP), die mit dem ersten Ausgang (10.1) des Differenzverstärkers (AMP) verbunden ist,
mit einem Stromspiegel (DIO, NMOS2), der mit dem zweiten Ausgang (10.2) des Differenzverstärkers (AMP) verbunden ist,
mit einem Transistor (NMOS1) zur Beeinflussung der zu regelnden Spannung (VDD), wobei dessen Steuereingang mit dem Stromspiegel (DIO, NMOS2) und der Ladungspumpe (LP) verbunden ist.

2. Schaltungsanordnung nach Patentanspruch 1,
mit einem Kondensator (CAP) zum Speichern, der mit dem Steuereingang des Transistors (NMOS1) verbunden ist.

3. Schaltungsanordnung nach Patentanspruch 1 oder 2,
mit einem Spannungsteiler (R1, R2), der eingangsseitig mit der zu regelnden Spannung (VDD) verbindbar ist und ausgangsseitig mit dem Eingang des Differenzverstärkers (AMP) verbunden ist.

4. Schaltungsanordnung nach einem der Patentansprüche 1 bis 3,
bei der der Stromspiegel (DIO, NMOS2) einen ersten Stromspiegeltransistor (DIO) und einen zweiten Stromspiegeltransistor (NMOS2) aufweist.

5. Schaltungsanordnung nach einem der Patentansprüche 1 bis 4,
mit einem steuerbaren Oszillator (OSZ'), der zwischen den Differenzverstärker (AMP) und die Ladungspumpe (LP) geschaltet ist.

6. Schaltungsanordnung nach Patentanspruch 5,
bei der der steuerbare Oszillator (OSZ') als stromgesteuerter Oszillator ausgebildet ist.

7. Schaltungsanordnung nach einem der Patentansprüche 1 bis 6,
bei der der Transistor (NMOS1) als N-Kanal-MOS-Transistor ausgebildet sind.

8. Verwendung der Schaltungsanordnung nach einem der Patentansprüche 1 bis 7,
in einer tragbaren elektronischen Vorrichtung.

## Claims

1. Circuit arrangement for voltage regulation,
having a differential amplifier (AMP) with two inputs and two outputs, it being possible for a reference voltage (VREF) and a voltage (VDD) that is to be regulated to be applied to the inputs,
having a charge pump (LP), which is connected to the first output (10.1) of the differential amplifier (AMP),
having a current mirror (DIO, NMOS2), which is connected to the second output (10.2) of the differential amplifier (AMP),
having a transistor (NMOS1) for influencing the voltage (VDD) to be regulated, the control input of said transistor being connected to the current mirror (DIO, NMOS2) and the charge pump (LP).

2. Circuit arrangement according to Patent Claim 1,
having a capacitor (CAP) for storage, which is connected to the control input of the transistor (NMOS1).

3. Circuit arrangement according to Patent Claim 1 or 2,
having a voltage divider (R1, R2), which, on the input side, can be connected to the voltage (VDD) to be regulated and, on the output side, is connected to the input of the differential amplifier (AMP).

4. Circuit arrangement according to one of Patent Claims 1 to 3,
in which the current mirror (DIO, NMOS2) has a first current mirror transistor (DIO) and a second current mirror transistor (NMOS2).

5. Circuit arrangement according to one of Patent Claims 1 to 4,
having a controllable oscillator (OSZ'), which is connected between the differential amplifier (AMP), and the charge pump (LP).

6. Circuit arrangement according to Patent Claim 5,
in which the controllable oscillator (OSZ') is designed as a current-controlled oscillator.

7. Circuit arrangement according to one of Patent Claims 1 to 6,
in which the transistor (NMOS1) is designed as an N-channel MOS transistor.

8. The use of the circuit arrangement according to one of Patent Claims 1 to 7,
in a portable electronic device.

## Revendications

1. Circuit de régulation de tension,
comprenant un amplificateur (AMP) différentiel ayant deux entrées et deux sorties, une tension (VREF) de référence et
une tension (VDD) à régler pouvant être appliquée aux entrées, une pompe (LP) de charge, qui est reliée à la première partie (10.1) de l'amplificateur (AMP) différentiel,
un miroir (DIO, NMOS2) de courant, qui est relié à la deuxième sortie (10.2) de l'amplificateur (AMP) différentiel,
un transistor (NMOS1) pour influencer la tension (VDD) à réguler, dont l'entrée de commande est reliée au miroir (DIO, NMOS2) de courant et à la pompe (LP) de charge.

2. Circuit de régulation de tension suivant la revendication 1,
comprenant un condensateur (CAP) d'emmagasinage, qui est relié à l'entrée de commande du transistor (NMOS1).

3. Circuit de régulation de tension suivant la revendication 1 ou 2,
comprenant un diviseur (R1, R2) de tension, qui peut être relié du côté entrée à la tension (VDD) à réguler et qui est relié côté sortie à l'amplificateur (AMP) différentiel.

4. Circuit de régulation de tension suivant l'une des revendications 1 à 3,
dans lequel le miroir (DIO, NMOS2) de courant a un premier transistor (DIO) de miroir de courant et un deuxième transistor (NMOS2) de miroir de courant.

5. Circuit de régulation de tension suivant l'une des revendications 1 à 4,
comprenant un oscillateur (OSZ') pouvant être commandé et monté entre l'amplificateur (AMP) différentiel et la pompe (LP) de charge.

6. Circuit de régulation de tension suivant la revendication 5,
dans lequel l'oscillateur (OSZ') pouvant être commandé est constitué en oscillateur commandé par le courant.

7. Circuit de régulation de tension suivant l'une des revendications 1 à 6,
dans lequel le transistor (NMOS1) est constitué sous la forme d'un transistor MOS à canal N.

8. Utilisation d'un circuit de régulation de tension suivant l'une des revendications 1 à 7,
dans un dispositif électronique portatif.
